# EUROPEAN PATENT APPLICATION

(11) **EP 4 083 570 A1**
(43) Date of publication of application: **02.11.2022**
(21) Application number: 21171106.4
(22) Date of filing: 29.04.2021
(51) Int. Cl.: G01B 11/27, G03F 7/20, H05G 2/00

(54) **LASER BEAM METROLOGY SYSTEM, LASER BEAM SYSTEM, EUV RADIATION SOURCE, AND LITHOGRAPHIC APPARATUS**

(71) Applicant: ASML Netherlands B.V., 5500 AH Veldhoven (NL)
(72) Inventor: BEEKER, Willem, Paul, 5500 AH Veldhoven (NL); ANANDAN, Krishna Prashanth, 5500 AH Veldhoven (NL); GANGULY, Vasishta, Parthasarathy, 5500 AH Veldhoven (NL)
(74) Representative: ASML Netherlands B.V.

(57) **Abstract**

A laser beam metrology system (400) configured to co-operate with a laser beam system that is configured to sequentially direct a first laser beam pulse (440) and a second laser beam pulse (430) to a target along two independent optical paths is described, the laser beam metrology system (400) comprising a first optical element (410) and a retro-reflector (460).

## Description

### FIELD

The present invention relates to a laser beam metrology system as can be applied in a laser beam system for an EUV radiation source. The laser beam metrology system can assess a characteristic of multiple laser beams that are used to hit a target, e.g. a target in an EUV radiation source.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In order to obtain the required EUV radiation, an EUV lithographic apparatus makes use of an EUV radiation source. Such a radiation source may generate pulses of EUV radiation by targeting tin droplets with laser pulses. In known radiation sources, the EUV radiation is generated by hitting a tin droplet by a first laser pulse, which may be referred to as a pre-pulse, followed by a second laser pulse, which may be referred to as a main pulse. In order to ensure an efficient conversion of the laser pulse energy to EUV radiation, an accurate alignment between the laser beam pulses and the target is required. Known systems to determine such an alignment, may be prone to measurement errors introduced by a complex routing of laser beam signals to a metrology system.

### SUMMARY

It is an objective of the present invention to provide a laser beam metrology system that enables a more accurate alignment of laser beam pulses to a target such as a fuel of an EUV radiation source. Therefore, according to an aspect of the present invention, there is provided a laser beam metrology system configured to co-operate with a laser beam system that is configured to sequentially direct a first laser beam pulse and a second laser beam pulse to a target along two independent optical paths, the laser beam metrology system comprising:
- a first optical element configured to:
   ▪ reflect a portion of the second laser beam pulse along a first direction;
   ▪ receive a reflection of the first laser beam pulse, the reflection being reflected off of the target;
   ▪ reflect a portion of the reflection of the first laser beam pulse along a direction substantially opposite to the first direction;
- a retro-reflector configured to:
   ▪ receive the portion of the reflection of the first laser beam pulse, and
   ▪ retro-reflect the portion of the reflection of the first laser beam pulse substantially along the first direction;
   wherein the first optical element is further configured to:
   ▪ receive the retro-reflected portion of the reflection of the first laser beam pulse, and
   ▪ transmit a portion of the retro-reflected portion of the reflection of the first laser beam pulse substantially along the first direction.

According to a further aspect of the present invention, there is provide a laser beam system comprising:
- a first laser beam source configured to generate a plurality of first laser beam pulses;
- a second laser beam source configured to generate a plurality of second laser beam pulses;
- an optical assembly configured to direct the plurality of first laser beam pulses and the plurality of second laser beam pulses to a respective plurality of targets;
- a control system configured to control the first laser beam source, the second laser beam source and the optical assembly to sequentially direct a first laser beam pulse of the plurality of first laser beam pulses and a second laser beam pulse of the plurality of second laser beam pulses onto a target of the plurality of targets, and
- a laser beam metrology system according to the present invention.

According to yet another aspect of the present invention, there is provided an EUV radiation source comprising:
- a laser beam system according to the present invention, and
- a fuel emitter configured to generate the plurality of targets.

According to yet another aspect of the present invention, there is provided a lithographic system comprising:
- an EUV radiation source according to the present invention, and
- a lithographic apparatus.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source according to the present invention;
- Figure 2 depicts a laser beam system according to an embodiment of the present invention;
- Figures 3a-3c depict an operation of a laser beam system according to an embodiment of the present invention.
- Figures 4 and 5 schematically depict laser beam metrology systems according to embodiments of the present invention.

### DETAILED DESCRIPTION

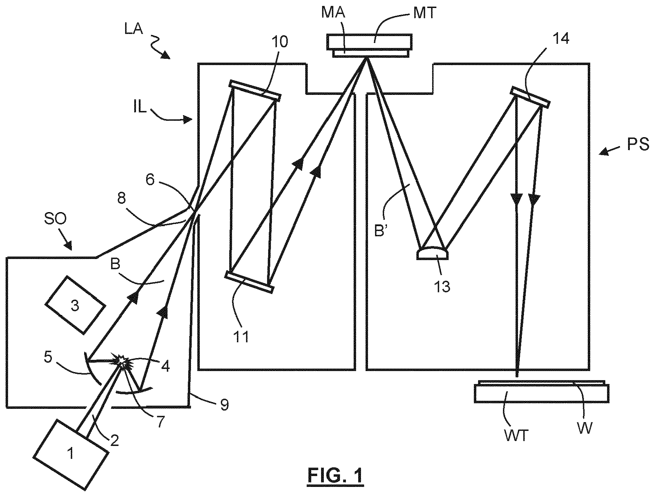

Figure 1 shows a lithographic system according to the present invention comprising a radiation source SO and a lithographic apparatus LA. The radiation source SO, e.g. an EUV radiation source according to the present invention, is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. The laser system 1 can e.g. comprise a laser beam system according to the present invention, said laser beam system comprising a laser beam metrology system according to the present invention. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

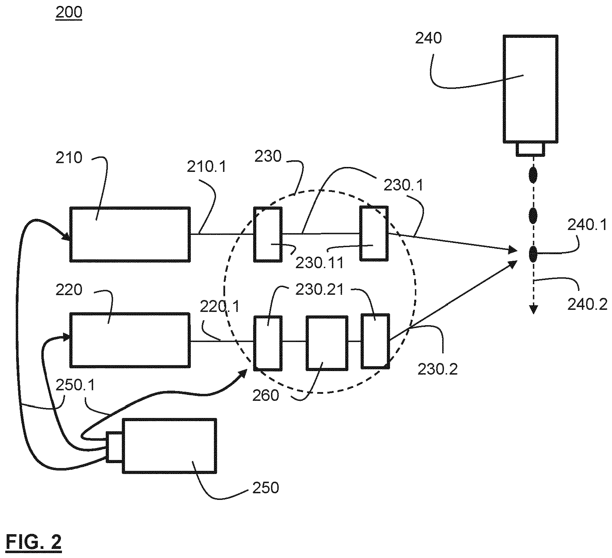

According to an aspect of the present invention, there is provided a laser beam metrology system. In one embodiment, the laser beam metrology system is comprised in a laser beam system which can be used in an EUV radiation source such as an LPP source. For sake of clarity, the laser beam metrology system is explained in the context of a laser beam system, but all elements related to the laser beam metrology system are operatively outside the context of the laser beam system. A laser beam system 200 according to an embodiment of the present invention is schematically shown in Figure 2. In accordance with the invention, the laser beam system 200 is configured to generate a plurality of first laser beam pulses 210.1 by means of a first laser beam source 210. Said first laser beam pulses are generated and emitted in sequence by the first laser beam source 210. The laser beam system 200 further comprises a second laser beam source 220 configured to generate a plurality of second laser beam pulses. Said second laser beam pulses are generated and emitted in sequence by the second laser beam source 220.

The laser beam system 200 further comprises an optical assembly 230 configured to direct the plurality of first laser beam pulses and the plurality of second laser beam pulses to a respective plurality of targets. In case the laser beam system 200 is applied in an EUV radiation source, the plurality of targets can e.g. be a stream of tin droplets 240.1 that are emitted, in sequence, by a fuel emitter 240 as shown in Figure 1. In accordance with the present invention, the laser beam system 200 further comprises a control system 250 configured to control the first laser beam source, the second laser beam source and the optical assembly to sequentially direct a first laser beam pulse of the first plurality of laser beam pulses 210.1 and a second laser beam pulse of the plurality of second laser beam pulses 220.1 onto a target of the plurality of targets. As such, when a target 240.1 of the plurality of targets is hit by a first laser beam pulse of the plurality of first laser beam pulses 210.1, it will at a later instant be hit by a second laser pulse of the plurality of second laser beam pulses 220.1. This can e.g. be done by providing suitable control signals 250.1 to the laser beam sources 210 and 220 and to the optical assembly 230. The optical assembly 230 of the laser beam system 200 according to the present invention may comprise various components 230.11 and 230.21 such as mirrors or lenses to guide the laser beam pulses 210.1 and 220.1 towards the stream of targets 240.1. The laser beam system 200 further comprises a laser beam metrology system 260 according to the present invention. Such a laser beam metrology system is described in more detail below.

In the embodiment as shown, the optical assembly 230 is configured to provide a first optical path 230.1 for the plurality of first laser beam pulses 210.1 between the first laser beam source 210 and the target 240.1. One or more components, 230.11, also referred to as guiding elements, may be used along said first optical path 230.1 to suitably guide and shape the laser beam pulses 210.1. The optical assembly 230 is further configured to provide a second optical path 230.2 for the plurality of second laser beam pulses 220.1 between the second laser beam source 220 and the target 240.1. Various components 230.21, also referred to as guiding elements, may be used along said second optical path 230.2.

In the embodiment as shown, the first and the second optical path 230.1, 230.2 are separated from each other, i.e. they do not coincide. The first and second optical paths 230.1 and 230.2 may thus be referred to as independent optical paths. As such, in an embodiment, the first optical path and the second optical path, from the laser sources to the target, are physically in different positions or locations. In such embodiment, the plurality of first and second laser beam pulses do not share any optical path from the source to the target. In the embodiment as shown, the first laser beam pulses and the second laser beam pulses are generated by different laser beam sources 210 and 220. This facilitates the application of pulses with different characteristics, e.g. power and/or radiation wavelength, for the plurality of first laser beam pulses and the plurality of second laser beam pulses. In an embodiment, the laser beam sources may be configured to generate pulses having a different radiation frequency. As an example, the first laser source 210 may e.g. be configured to generate laser beam pulses having a radiation wavelength of approx. 1 µm or around 1 µm, e.g. 1028 nm, whereas the second laser source 220 may e.g. be configured to generate laser beam pulses having a radiation wavelength of approx. 10 µm, e.g. 10.6 µm. In an embodiment, a radiation wavelength of the plurality of second laser beam pulses is between 5 and 25 times larger than a radiation wavelength of the plurality of first laser beam pulses. In an embodiment, the radiation wavelength of the plurality of second laser beam pulses is 10 times larger than the radiation wavelength of the plurality of first laser beam pulses.

In case the laser beam system 200 is used to generate EUV radiation, by sequentially targeting the tin droplets 240.1 with a first laser beam pulse 210.1 and second laser beam pulse 220.2, it is preferred to ensure that the laser beam pulses 210.1 and 220.1 are suitably aimed at the target 240.1 and hit the target at a predetermined location, thus ensuring the most effective conversion to EUV radiation. In case the laser beam system 200 is applied in an LPP EUV source, the laser beam pulses may be configured to hit the tin targets at a plasma formation region, such as plasma formation region 4 shown in Figure 1.

The deposition of laser energy into the tin droplet, e.g. target 240.1 creates a tin plasma, e.g. at the plasma formation region 4. Radiation, including EUV radiation, is emitted from the plasma during de-excitation and recombination of electrons with ions of the plasma. It has been observed that a more efficient conversion to EUV radiation can be obtained when the deposition of laser energy is done with two or more laser pulses. The laser beam system 200 according to the present invention may advantageously be applied to do so. In particular, the laser beam system 200 may be configured to hit at a first instant, a target 240.1 with a first laser beam pulse 210.1 emitted by the first laser source 210 and, at a later second instant, hit the target 240.1 with a second laser beam pulse 220.1 emitted by the second laser beam source 220. In such an arrangement, the first laser beam pulse 210.1 will cause the target 240.1, e.g. a tin droplet, to transform the shape of the droplet. During the period between the hitting of the target 240.1 by the first laser beam pulse 210.1 and the hitting of the target 240.1 by the second laser beam pulse, the target 240.1, may e.g. be transformed from a droplet, e.g. having a substantially spherical shape, into a more flattened object, e.g. a disk or pancake shaped object. During said period, the target, either the tin droplet or the flattened object, will also continue to propagate along the trajectory 240.2 of the targets 240.1.

In accordance with the present invention, the first laser beam pulse 210.1 emitted at a first instant may e.g. be referred to as a pre-pulse. The second laser beam pulse 220.1 emitted at the later, second instant may e.g. be referred to as a main pulse. It may further be noted that, in an embodiment of the present invention, the firing of the main pulse, e.g. laser beam pulse 220.1, may be preceded by the firing of multiple pre-pulses. When the target, e.g. the flattened tin droplet is hit by the second laser beam pulse 220.1, it is transformed into a plasma which can emit EUV radiation. In a preferred embodiment, a cross-sectional size of the second laser beam pulse 220 substantially is larger than a size of the flattened tin droplet. Preferably, the trajectory of the second laser beam pulse 220.1 is such that the second laser beam pulse 220.1 overlaps with the flattened tin droplet.

In order to ensure the most effective generation of the EUV radiation, it will be understood that the laser beam pulses as applied should hit the droplet or target at a preferred location. Both laser pulses, i.e. the first laser beam pulse and the second laser beam pulse, should thus be aimed accurately at the target, e.g. target 240.1. Note that, in the present invention, target may refer to the element or feature that is to be hit by any of the laser beam pulses as generated. It may thus, in an embodiment, refer to a tin droplet as e.g. generated by an emitter such as emitter 240, or may refer to a transformed droplet, e.g. transformed by an interaction with a previously fired laser beam pulse. In order to assess whether pulses are aimed accurately at their target, the laser beam system 200 according to an embodiment of the present invention further comprises a laser beam metrology system 260 according to the present invention. Using the laser beam metrology system 260, which will be explained in more detail below, an assessment is made whether the pulses are aimed accurately at the target.

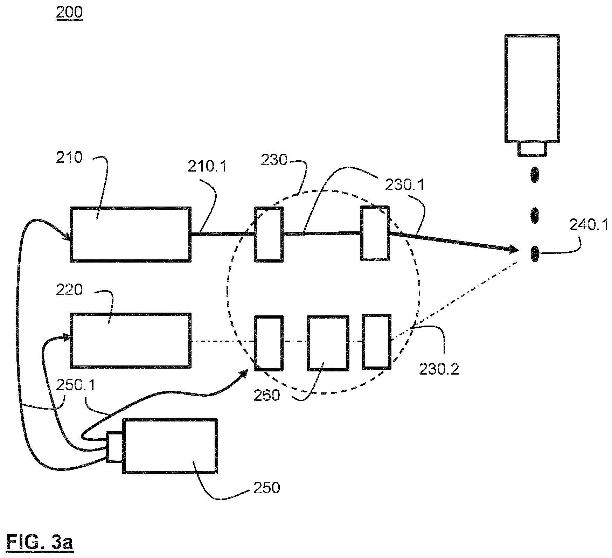

In order to do so, the laser beam metrology system 260 according to the present invention is configured to receive at least part of the second laser beam pulse 220.1 that is aimed at the target 240, but also at least part of a reflection of the first laser beam pulse 210.1, which has been fired at the target 240.1 earlier. This is explained in more detail in Figures 3a-3c.

Figure 3a schematically shows the laser beam system 200 of Figure 2 at the instant where the first laser beam source 210 fires a first laser beam pulse 210.1 along the first optical path 230.1 to the target 240.1. The dotted line 230.2 indicated the second optical path of the laser beam system, i.e. the optical path along which laser pulses are fired by the second laser beam source 220. It may however be pointed out that, as will be understood by the skilled person, that the first optical path 230.1 and the second optical path 230.2 do not actually meet at the same target location. Rather, due to the movement of the target 240.1, the location at which the target 240.1 is hit by the second laser beam pulse 220.1 is somewhat downstream of the location where the target 240.1 is hit by the first laser beam pulse 210.1

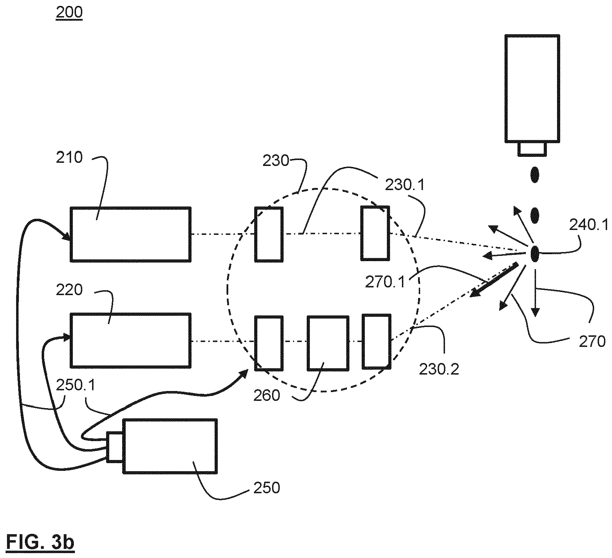

Figure 3b schematically illustrates the effect of the laser beam pulse 210.1 on the target 240.1. As a result of the laser beam pulse 210.1, reflections of the laser beam pulse 210.1 will occur in various directions, indicated by the arrows 270. Of these reflections 270, a reflection 270.1 may occur that is substantially or approximately directed along the second optical path 230.2 of the laser beam system 200. In accordance with the present invention, this reflection 270.1 of the first laser beam pulse 210.1 fired by the first laser beam source 210 can propagate along an optical path which may resemble or approximate or substantially correspond to the second optical path, in opposite direction compared to the second laser beam pulse 220.1, and can be received by the laser beam metrology system 260 that is arranged in said second optical path 230.2. Taking account of a typical displacement of the target 240.1 between the instant when the target is hit by the first laser beam pulse 210.1 and the instant at which the target 240.1, i.e. the somewhat transformed target, is hit by the second laser beam pulse 220.1, an angular difference between the reflection 270.1 of the first laser beam pulse 210.1 and the second laser beam pulse may e.g. be a few mrad.

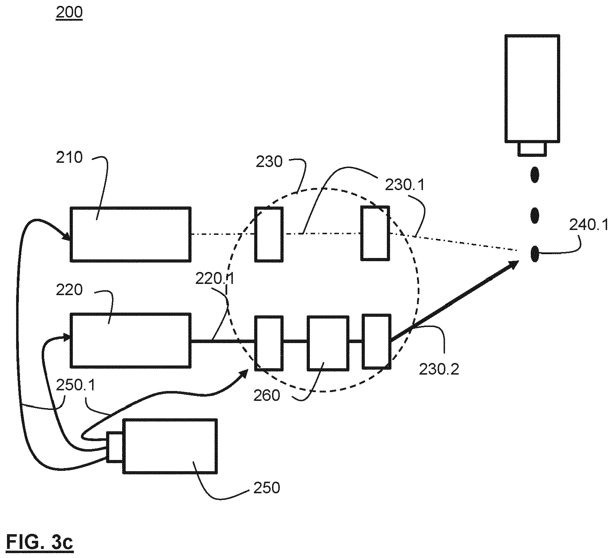

Figure 3c schematically shows the instant at which the second laser beam pulse 220.1 is fired by the second laser beam source 220, along the second optical path 230.2, towards the target 240.1. In accordance with the present invention, said second laser beam pulse 220.1 is also received by the laser beam metrology system 260 that is arranged in the second optical path.

In an embodiment, the laser beam metrology system 260 as schematically shown in Figures 2, 3a-3c, can be configured to determine a characteristic of said received pulses, in particular the reflection 270.1 of the first laser beam pulse 210.1 and the second laser beam pulse 220.1. In an embodiment, the laser beam metrology system 260 may e.g. be configured to determine a relative orientation of both received pulses. In this respect, it can be pointed out that, due to the use of two different optical paths 230.1 and 230.2, the first laser beam pulse 210.1 emitted by the first laser beam source 210 is not received by the laser beam metrology system 260. As will be explained further on, this is advantageously be applied in the design of the laser beam metrology system according to the present invention.

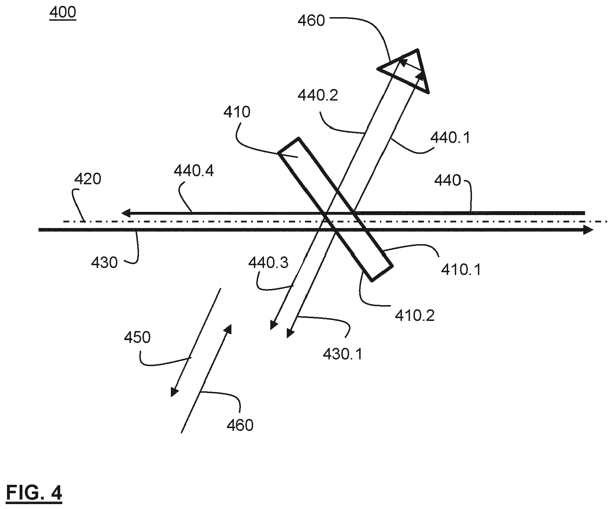

Figure 4 schematically shows an embodiment of a laser beam metrology system 400 according to the present invention. Such a laser beam metrology system 400 may e.g. be applied as a laser beam metrology system 260 in the laser beam system 200 shown in Figures 2, 3a-3c.

The laser beam metrology system 400 according to an embodiment of the present invention may advantageously be used in a laser beam system, e.g. laser beam system 200, that is configured to sequentially direct a first laser beam pulse, e.g. a pre-pulse (PP), and a second laser beam pulse, e.g. a main pulse (MP) to a target.

In the embodiment as shown, the laser beam metrology system 400 comprises a first optical element 410 that is arranged in an optical path 420. Referring to Figures 2, 3a-3c, said optical path 420 may be the optical path 230.2, i.e. the optical path along which a second laser beam pulse is fired towards a target and along which a reflection of a first laser beam pulse propagates, albeit in opposite direction.

In the embodiment as shown, arrow 430 indicates a second laser beam pulse propagating along the optical path 420. In the embodiment as shown, arrow 440 indicates a reflection of a first laser beam pulse that propagates along the optical path 420. Said reflection 440 may e.g. be caused by the first laser beam pulse hitting a target. In the embodiment as shown, the first optical element 410, which is arranged in the optical path 420, is configured to:
- reflect a portion 430.1 of the second laser beam pulse 430 along a first direction indicated by the arrow 450;
- receive a reflection of the first laser beam pulse 440, the reflection being reflected off a target;
- reflect a portion 440.1 of the reflection of the first laser beam pulse along a direction 460 substantially opposite to the first direction 450.

With respect to the reflections at the first optical element 410, it can be pointed out that, in general, reflections will occur at both the front surface and the back surface of the element. In an embodiment, one can design the first optical element 410 such that only one of said reflections is used for the measurements. As an example, the optical element 410 may e.g. be designed such that a reflection of portion 440.1 of the reflection of the first laser beam pulse occurs at a back surface of the first optical element 410, and that portion 430.1 of the second laser beam pulse 430 also occurs at the back surface of the first optical element. Alternatively, both reflected portions 440.1 and 430.1 may occur at a front surface of the first optical element 410 or both reflections may occur at different surfaces. In this respect, the back surface of the first optical element may e.g. refer to surface 410.1 which is closest to the target, whereas the front surface of the first optical element may e.g. refer to surface 410.2 which faces the incoming second laser beam pulse 430. In the embodiment as shown in Figure 4, it can be seen that the portion 430.1 of the second laser beam pulse 430 is indicated as being reflected at the front surface 410.2, whereas the portion 440.1 of the reflection of the first laser beam pulse 440 is indicated as being reflected at the back surface 410.1 of the first optical element 410.

In the embodiment as shown, the laser beam metrology system 400 further comprises a retro-reflector 460, that is configured to:
- receive the portion 440.1 of the reflection of the first laser beam pulse 440, and
- retro-reflect the portion 440.1 of the reflection of the first laser beam pulse substantially along the first direction 450, as indicated by the arrow 440.2.

As an example of such a retro-reflector 460, a corner cube can be mentioned. Other types of retroreflectors may however be considered as well. The retro-reflector 460 can e.g. comprises a glass cube, e.g. made from fused silica, whereby outer surfaces are coated, e.g. with a metal or other reflecting material layer.In the embodiment as shown, the first optical element 410 is further configured to:
- receive the retro-reflected portion 440.2 of the reflection of the first laser beam pulse 440, and
- emit (or transmit) a portion 440.3 of the retro-reflected portion of the reflection of the first laser beam pulse substantially along the first direction 450.

As a result, the laser beam metrology system 400 according to an embodiment of the present invention is configured to emit, along substantially the same direction, i.e. the first direction 450 as indicated, a signal 430.1 representing a second laser beam pulse that was fired at a target and a signal 440.3 representing a reflection of a first laser beam pulse that was fired at the target. By the particular optical components 410, 460, as used, said signals 430.1 and 440.3 may propagate further along substantially the same optical path. In practice, the path followed by the portion 440.3 of the retro-reflected portion of the reflection of the first laser beam pulse, also referred to as the signal 440.3, and the reflected portion 430.1 of the second laser beam pulse 430, also referred to as the signal 430.1, may substantially coincide. As a result of this, any further optical components required to guide the signal 430.1 and 440.3 may be in common for both signals, thus avoiding that the spatial relationship between both signals becomes disturbed.

It can further be pointed out that the laser beam metrology system 400 thus enables, with only the use of a few optical components, to generate a signal 430.1, representing a second laser beam pulse, and a signal 440.3, representing a reflection of a first laser beam pulse, in a substantially aligned or colinear manner. Based on these signals, as will be explained further on, a detection system may assess whether a laser beam pulse is accurately aimed at a target. In this respect, it can further be pointed out that the laser beam metrology system according to the present invention advantageously makes use of the separation of the optical paths of the first laser beam pulse and the second laser beam pulse. Because the first laser beam pulse that hits the target arrives at the target along an optical path that is different from optical path 420, the first laser beam pulse does not interfere or interact with the laser beam metrology system 200. In particular, the first laser beam pulse does not interfere or interact with the first optical element 410 and does not generate any reflections in the first direction.

In an embodiment, the first optical element 410 is configured to transmit at least 90% of the second laser beam pulse. Since the first optical element 410 of the laser beam metrology system 400 is arranged in the optical path 420 of the second laser beam pulse 430, e.g. a main pulse for hitting the target, it may be advantageous to ensure that only a small portion of the second laser beam pulse 430 is reflected. Preferably more than 95% or more than 99% of the second laser beam pulse 430 is transmitted through first optical element 410. In an embodiment, a transmission of approx. 99.7 % is realized.

In an embodiment, the first optical element 410 is configured to transmit 30 - 70 % of the first laser beam pulse, e.g. a pre-pulse for hitting a target, preferable 40 - 60 %. As can be seen from Figure 4, the part or portion 440.3 of the retro-reflected portion 440.2 of the reflection 440 of the first laser beam pulse that is emitted or transmitted has first undergone a reflection at the first optical element 410 and, after a retro-reflection in the optical element 460, has undergone a transmission through the first optical element 410. An optimal value for both the transmission and reflectivity would thus be 50%, resulting in 25% of the reflection 440 arriving as the signal 440.3. in such case, approx. 50% of the reflection of the first laser beam pulse 440 would then be transmitted through the first optical element 410, said component being indicated by reference number 440.4. It can be pointed out that there is no need to optimize the characteristics of the first optical element with respect to the transmission and the reflectivity of radiation having a wavelength corresponding to a wavelength of the first laser beam pulse. Rather, it is more relevant to aim for a high transmission of radiation having a wavelength corresponding to a wavelength of the second laser beam pulse. Said second laser beam pulse, or main pulse will typically have a larger power than the first laser beam pulse. It is therefore relevant to ensure that a dissipation or absorption of power of the second laser beam pulse is kept low, in order to avoid adverse heating effects in the first optical element 410. As such, transmissibility of the first optical element may also be in a range of 10% - 90% or even in range of 1% to 99%. When the laser beam metrology system is used in a laser beam system of an EUV radiation source, the power of the main pulses may be considerable. The first optical element 410 should be able to withstand such a load. As an example, the first optical element can comprise a diamond substrate. The diamond substrate can e.g. be coated, e.g. with an anti-reflective coating to realize the required high transmission for the laser beam pulses, in particular the second laser beam pulses. In an embodiment, both sides of the diamond substrate can be coated. One side may e.g. be coated with a slightly different coating to obtain a non-zero reflectivity for the second laser beam pulses, at one side of the first optical element.

In order to obtain the desired values for the reflectivity and transmissibility of the first optical element, the first optical element may be designed taking account of the radiation wavelength of the first and second laser beam pulses. In an embodiment of the present invention, first laser beam pulses may e.g. have a wavelength of ∼ 1 µm, whereas the second laser beam pulses may e.g. have a wavelength of ∼ 10 µm.

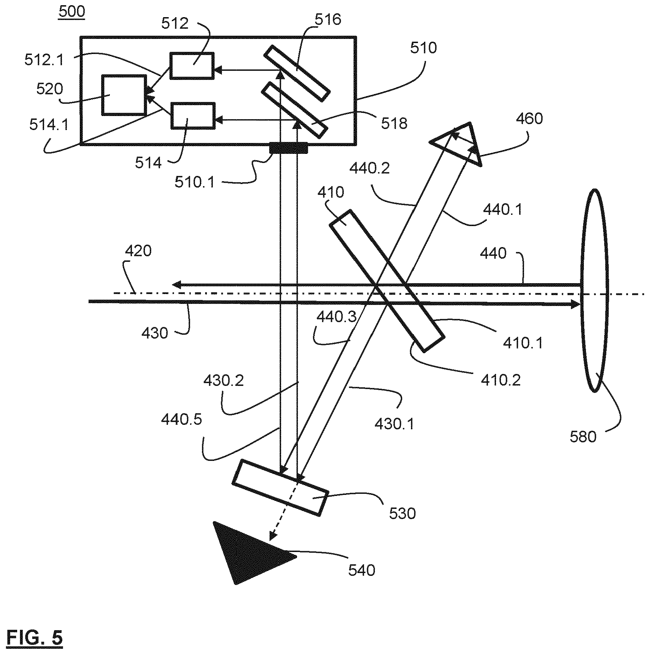

In an embodiment, the laser beam metrology system according to the present invention further comprises a detection system. Such a laser beam metrology system is schematically shown in Figure 5.

Figure 5 schematically shows a laser beam metrology system 500 according to the present invention, the metrology system 500 comprising, in addition to the laser beam metrology system 400 as shown in Figure 4, a detection system 510. In the embodiment as shown, the detection system 510 is configured to:
- receive the reflected portion 430.1 of the second laser beam pulse 430, and
- receive the portion 440.3 of the retro-reflected portion of the reflection of the first laser beam,
- determine a relative orientation between the reflection of the first laser beam pulse and the second laser beam pulse.

In the embodiment as shown, the portions 430.1 and 440.3 derived from the second laser beam 430 and the reflected first laser beam 440 respectively, are first received by optical element 530 that is configured to at least partially reflect the portions 430.1 and 440.3. The reflected portions or parts reflected off of the second optical element 530 are indicated as 440.5 and 430.2, reference number 440.5 indicating the part of portion 440.3 that is reflected off of element 530 and reference number 430.2 indicating the part of portion 430.1 that is reflected off of element 530.

Based on a determined relative orientation or direction of the reflection of the first laser beam pulse and the second laser beam pulse, a control system of the laser beam system according to the invention, e.g. laser beam system 200 shown in Figures 2, 3a-3c, can be configured to control the laser beam sources 210 or 220 or the optical assembly 230. In this respect, it can be pointed out that the relative orientation of interest is the relative orientation between the reflection of the first laser beam pulse, as reflected off the target 240.1, and the direction of the second laser beam pulse towards the target 240.1. Since both the reflection of the first laser beam pulse and the second laser beam pulse are received by the same first optical element, said relative orientation is maintained throughout the measurement system. Phrased differently, the relative orientation between reflection 430.1 of the second laser beam pulse 430 and the portion 440.3 of the retro-reflected portion 440.2 of the reflection of the first laser beam 440 is substantially the same as the relative orientation between the reflection of the first laser beam pulse, as reflected off the target 240.1, and the direction of the second laser beam pulse towards the target 240.1. Based on the determined relative orientation, an assessment can be made of the accuracy at which the laser beam pulses are aimed at the target. As such, the determined relative orientation, which can also be referred as an angle between a chief ray of the received reflection of the first laser beam pulse and a chief ray of the second laser beam pulse, provides feedback to the control system of the laser beam system according to the present invention. Said feedback can e.g. be used by the control system to control an operation of the laser beam sources, e.g. a timing or orientation of the laser beam pulses as generated, and/or to control an operation of the optical assembly of the laser beam system, e.g. a position or an orientation of one or more elements of the optical assembly of the laser beam system, e.g. optical assembly 230 of laser beam system 200. The relative orientation of the reflection of the first laser beam pulse and the second laser beam pulse can also be referred to as a beam angle offset. It is desirable to keep this relative orientation or beam angle offset below a predetermined value, in order to ensure proper or desired alignment of the laser beam pulses with the target. As mentioned above, the hitting of the target 240.1 by the first laser beam pulse will cause a transformation of the target, e.g. to a flattened shape. To allow this transformation, a certain time period is needed, during which the target will move further. The distance moved by the target during said time period, corresponding to the time period between the application of the first laser beam pulse and the second laser beam pulse, can e.g. be ∼ 200 µm. Based on this distance and information about the optical layout of the laser beam system, one can than determine the required angular difference, or relative orientation, between the second laser beam pulse and the reflection of the first laser beam pulse as reflected off of the target 240.1. Typically, the required angular difference may e.g. be 1 -2 mrad.

In the embodiment shown in Figure 5, the detection system 510 is configured to receive the reflected portion 430.1 of the second laser beam pulse, and the portion 440.3 of the retro-reflected portion of the reflection of the first laser beam pulse via a common entrance window 510.1. In the embodiment as shown, the detection system 510 is configured to:
- direct the portion 440.3 of the retro-reflected portion of the reflection of the first laser beam pulse to a first sensor 512 of the detection system 510, and
- direct the reflected portion 430.1 of the second laser beam pulse to a second sensor 514 of the detection system 510.

It can be pointed out that, as will be shown below, that the detection system 510 only receives a part or a portion of the signals 430.1 and 440.3. Phrased differently, the intensity of the signals 430.1 and 440.3 that are reflected resp. transmitted by the first optical element 410, may be further reduced along the optical path that guides those signals to the detection system 510.

In the embodiment as shown, the detection system 510 comprises two reflectors 516, 518 to direct the received portions 430.1 and 440.3 to the first and second sensors 512, 514. As will be appreciated by the skilled person, the reflectors 516, 518 need to have the required reflectivity and transmissibility to enable the signals 430.1 and 440.3 to be guided towards the sensors 512, 514. It may also be pointed out that by changing the layout of the sensors 512, 514, it may be sufficient to only use one reflector.

In an embodiment, it may be sufficient to only use one sensor as well, provided the sensor is sufficiently sensitive to the radiation wavelength of both the first laser beam pulse and the second laser beam pulse. In an embodiment of the present invention, first laser beam pulses may e.g. have a wavelength of ∼1 µm, whereas the second laser beam pulses may e.g. have a wavelength of -10 µm. In such embodiment, it may be preferred to apply two distinct sensors.

In the embodiment as shown, the first sensor 512 of the detection system 510 is configured to provide a first signal 512.1 representing a position of the portion 440.3 of the retro-reflected portion of the reflection of the first laser beam pulse on the first sensor 512, and the second sensor 514 is configured to provide a second signal 514.1 representing a position of the reflected portion 430.1 of the second laser beam pulse on the second sensor 514. The detection system 510 further comprises a processing unit 520, the processing unit 520 being configured to determine the relative orientation between the reflection of the first laser beam pulse and the second laser beam pulse based on the first signal 512.1 and the second signal 514.1. In an embodiment, the processing unit 520 may further output an output signal representing the relative orientation of the reflection of the first laser beam pulse and the second laser beam pulse. Such an output signal may then be used by the control system of the laser beam system that incorporates the laser beam metrology system. It can be pointed out that, as an alternative, the processing unit 520 of the laser beam metrology system 500 may also be incorporated in a control system of the laser beam system in which the metrology system is applied.

In the embodiment as shown, the laser beam metrology system 500 further comprising a second optical element 530 configured to:
- redirect a part 430.2 of the reflected portion 430.1 of the second laser beam pulse 430 to the detector system 510, and
- redirect a part 440.5 of the portion 440.3 or the portion 440.3 of the retro-reflected portion of the reflection of the first laser beam pulse to the detector system 510.

In the embodiment as shown, the second optical element 530 is designed in such manner that a part 430.2 of the signal 430.1, i.e. the reflected portion of the second laser beam pulse 430, is transmitted through the element 530 and ends up in a beam dump 540 where excess energy of the signal 430.1 is absorbed. Depending on the strength of the signals 430.1 and 440.3 and the requirements of the detection system 510, in particular the desired signal strength arriving on the sensors 512, 514, reflectors 516 and 518 and the second optical element 530 may be designed in such manner that the required intensity is received at the sensors. As an example, reflector 518 may also be designed to partially transmit the received part 430.2 of the signal 430.1 such that only a further reduced part of signal 430.1 arrives at the sensor 514.

In the embodiment as shown, the first optical element 410 comprises a first surface 410.1 to receive the reflection 440 of the first laser beam pulse and a second surface 410.2 to receive the second laser beam pulse 430. In an embodiment, said surfaces are substantially parallel to each other. In an embodiment, the first and second surface 410.1 and 420.2 are arranged in a non-parallel manner. The first optical element 410 may thus be wedge-shaped. By doing so, any unwanted reflections can be discarded or filtered. Referring to Figure 4, one can thus, by suitable shaping of the first optical element 410 ensure that only reflections occurring at the back surface 410.1 of the first optical element 410 are used by the metrology system 400 or 500, while reflections occurring at the front surface 410.2 are filtered out.

In the embodiment as shown, element 580 schematically represents a guiding element of an optical assembly of the laser beam system in which the laser beam metrology system is used. The guiding element 580 can e.g. be part of a focusing unit of the laser beam system which is configured to focus the second laser beam pulse 430 onto the target. In the arrangement as shown, the guiding element 580 is further configured to receive the reflection of the first laser beam pulse that was aimed at the target, and direct it along the optical path 420.

The laser beam system according to the present invention, which includes a laser beam metrology system according to the present invention may advantageously be applied in an EUV radiation source according to the present invention. By the application of a laser beam system according to the present invention in an EUV radiation source, an accurate assessment of the targeting of the laser beam pulses can be made, thus enabling an effective generation of EUV radiation.

The EUV radiation source according to the present invention may advantageously be used in an lithographic system according to the present invention, said system comprising an EUV radiation source according to the present invention and a lithographic apparatus. In such system, the lithographic apparatus can be configured to use the generated EUV radiation in an exposure process.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.
1. Laser beam metrology system configured to co-operate with a laser beam system that is configured to sequentially direct a first laser beam pulse and a second laser beam pulse to a target along two independent optical paths, the laser beam metrology system comprising:
   - a first optical element configured to:
      ▪ reflect a portion of the second laser beam pulse along a first direction;
      ▪ receive a reflection of the first laser beam pulse, the reflection being reflected off of the target;
      ▪ reflect a portion of the reflection of the first laser beam pulse along a direction substantially opposite to the first direction;
   - a retro-reflector configured to:
      ▪ receive the portion of the reflection of the first laser beam pulse, and
      ▪ retro-reflect the portion of the reflection of the first laser beam pulse substantially along the first direction;
   wherein the first optical element is further configured to:
   ▪ receive the retro-reflected portion of the reflection of the first laser beam pulse, and
   ▪ transmit a portion of the retro-reflected portion of the reflection of the first laser beam pulse substantially along the first direction.
2. The laser beam metrology system according to clause 1, further comprising a detection system configured to:
   - receive the reflected portion of the second laser beam, and
   - receive the portion of the retro-reflected portion of the reflection of the first laser beam,
   - determine a relative orientation between the reflection of the first laser beam pulse and the second laser beam pulse.
3. The laser beam metrology system according to clause 2, wherein the detection system is configured to receive the reflected portion of the second laser beam pulse, and the portion of the retro-reflected portion of the reflection of the first laser beam pulse via a common entrance window.
4. The laser beam metrology system according to clause 3, wherein the detection system is configured to:
   - direct the portion of the retro-reflected portion of the reflection of the first laser beam pulse to a first sensor of the detection system, and
   - direct the reflected portion of the second laser beam pulse to a second sensor of the detection system.
5. The laser beam metrology system according to clause 4, wherein the first sensor is configured to provide a first signal representing a position of the portion of the retro-reflected portion of the reflection of the first laser beam pulse on the first sensor, and wherein the second sensor is configured to provide a second signal representing a position of the reflected portion of the second laser beam pulse on the second sensor.
6. The laser beam metrology system according to clause 5, wherein the detection system comprises a processing unit, the processing unit being configured to determine the relative orientation between the reflection of the first laser beam pulse and the second laser beam pulse based on the first signal and the second signal.
7. The laser beam metrology system according to any of the preceding clauses, wherein the first optical element is configured to transmit at least 90% of the second laser beam pulse.
8. The laser beam metrology system according to any of the preceding clauses, wherein the first optical element is configured to transmit 10 - 90 % of the first laser beam pulse, preferable 40 -60 %.
9. The laser beam metrology system according to any of the preceding clauses, further comprising a second optical element configured to:
   - redirect a part of the reflected portion of the second laser beam pulse to the detector system, and
   - substantially redirect the portion of the retro-reflected portion of the reflection of the first laser beam pulse to the detector system.
10. The laser beam metrology system according to clause 9, wherein the part of the reflected portion of the second laser beam pulse and the portion of the retro-reflected portion of the reflection of the first laser beam pulse are redirected in substantially the same direction.
11. The laser beam metrology system according to any of the preceding clauses, wherein the first optical element comprises a first surface to receive the reflection of the first laser beam pulse and a second surface to receive the second laser beam pulse.
12. Laser beam system comprising:
   - a first laser beam source configured to generate a plurality of first laser beam pulses;
   - a second laser beam source configured to generate a plurality of second laser beam pulses;
   - an optical assembly configured to direct the plurality of first laser beam pulses and the plurality of second laser beam pulses to a respective plurality of targets;
   - a control system configured to control the first laser beam source, the second laser beam source and the optical assembly to sequentially direct a first laser beam pulse of the plurality of first laser beam pulses and a second laser beam pulse of the plurality of second laser beam pulses onto a target of the plurality of targets, and
   - a laser beam metrology system according to any of the preceding clauses.
13. The laser beam system according to clause 12, wherein the optical assembly is configured to:
   - provide a first optical path for the plurality of first laser beam pulses between the first laser beam source and the target, and
   - provide a second optical path for the plurality of second laser beam pulses between the second laser beam source and the target.
14. The laser beam system according to clause 13, wherein the first optical element of the laser beam metrology system is arranged in the second optical path.
15. The laser beam system according to clause 14, wherein the optical assembly comprises a first guiding element arranged in the second optical path, the first guiding element being configured to:
   - guide the second laser beam pulse along the second optical path towards the target, and
   - guide the reflection of the first laser beam pulse along substantially the second optical path towards the first optical element.
16. The laser beam system according to any of the clauses 12 to 15, wherein a radiation wavelength of the plurality of first laser beam pulses is different from a radiation wavelength of the plurality of second laser beam pulses.
17. The laser beam system according to clause 16, wherein the radiation wavelength of the plurality of second laser beam pulses is approx. 10 times higher than the radiation wavelength of the plurality of first laser beam pulses.
18. An EUV radiation source comprising:
   - a laser beam system according to any of the clauses 12 to 17, and
   - a fuel emitter configured to generate the plurality of targets.
19. Lithographic system comprising:
   - An EUV radiation source according to clause 18, and
   - A lithographic apparatus.

## Claims

1. Laser beam metrology system configured to co-operate with a laser beam system that is configured to sequentially direct a first laser beam pulse and a second laser beam pulse to a target along two independent optical paths, the laser beam metrology system comprising:
- a first optical element configured to:
▪ reflect a portion of the second laser beam pulse along a first direction;
▪ receive a reflection of the first laser beam pulse, the reflection being reflected off of the target;
▪ reflect a portion of the reflection of the first laser beam pulse along a direction substantially opposite to the first direction;
- a retro-reflector configured to:
▪ receive the portion of the reflection of the first laser beam pulse, and
▪ retro-reflect the portion of the reflection of the first laser beam pulse substantially along the first direction;
wherein the first optical element is further configured to:
▪ receive the retro-reflected portion of the reflection of the first laser beam pulse, and
▪ transmit a portion of the retro-reflected portion of the reflection of the first laser beam pulse substantially along the first direction.

2. The laser beam metrology system according to claim 1, further comprising a detection system configured to:
- receive the reflected portion of the second laser beam, and
- receive the portion of the retro-reflected portion of the reflection of the first laser beam,
- determine a relative orientation between the reflection of the first laser beam pulse and the second laser beam pulse.

3. The laser beam metrology system according to claim 2, wherein the detection system is configured to:
- direct the portion of the retro-reflected portion of the reflection of the first laser beam pulse to a first sensor of the detection system, and
- direct the reflected portion of the second laser beam pulse to a second sensor of the detection system.

4. The laser beam metrology system according to claim 4, wherein the first sensor is configured to provide a first signal representing a position of the portion of the retro-reflected portion of the reflection of the first laser beam pulse on the first sensor, and wherein the second sensor is configured to provide a second signal representing a position of the reflected portion of the second laser beam pulse on the second sensor, and wherein the detection system comprises a processing unit, the processing unit being configured to determine the relative orientation between the reflection of the first laser beam pulse and the second laser beam pulse based on the first signal and the second signal.

5. The laser beam metrology system according to any of the preceding claims, wherein the first optical element is configured to transmit at least 90% of the second laser beam pulse.

6. The laser beam metrology system according to any of the preceding claims, further comprising a second optical element configured to:
- redirect a part of the reflected portion of the second laser beam pulse to the detector system, and
- substantially redirect the portion of the retro-reflected portion of the reflection of the first laser beam pulse to the detector system.

7. The laser beam metrology system according to claim 6, wherein the part of the reflected portion of the second laser beam pulse and the portion of the retro-reflected portion of the reflection of the first laser beam pulse are redirected in substantially the same direction.

8. The laser beam metrology system according to any of the preceding claims, wherein the first optical element comprises a first surface to receive the reflection of the first laser beam pulse and a second surface to receive the second laser beam pulse.

9. Laser beam system comprising:
- a first laser beam source configured to generate a plurality of first laser beam pulses;
- a second laser beam source configured to generate a plurality of second laser beam pulses;
- an optical assembly configured to direct the plurality of first laser beam pulses and the plurality of second laser beam pulses to a respective plurality of targets;
- a control system configured to control the first laser beam source, the second laser beam source and the optical assembly to sequentially direct a first laser beam pulse of the plurality of first laser beam pulses and a second laser beam pulse of the plurality of second laser beam pulses onto a target of the plurality of targets, and
- a laser beam metrology system according to any of the preceding claims.

10. The laser beam system according to claim 9, wherein the optical assembly is configured to:
- provide a first optical path for the plurality of first laser beam pulses between the first laser beam source and the target, and
- provide a second optical path for the plurality of second laser beam pulses between the second laser beam source and the target.

11. The laser beam system according to claim 10, wherein the first optical element of the laser beam metrology system is arranged in the second optical path.

12. The laser beam system according to claim 11, wherein the optical assembly comprises a first guiding element arranged in the second optical path, the first guiding element being configured to:
- guide the second laser beam pulse along the second optical path towards the target, and
- guide the reflection of the first laser beam pulse along substantially the second optical path towards the first optical element.

13. The laser beam system according to any of the claims 9 to 12, wherein a radiation wavelength of the plurality of first laser beam pulses is different from a radiation wavelength of the plurality of second laser beam pulses.

14. The laser beam system according to claim 13, wherein the radiation wavelength of the plurality of second laser beam pulses is approx. 10 times higher than the radiation wavelength of the plurality of first laser beam pulses.

15. An EUV radiation source comprising:
- a laser beam system according to any of the claims 9 to 14, and
- a fuel emitter configured to generate the plurality of targets.
